(19) Europäisches Patentamt
European Patent Office
Office européen des brevets

(11) **EP 1 681 764 B1**

(12) **EUROPEAN PATENT SPECIFICATION**

(45) Date of publication and mention
of the grant of the patent:
**14.09.2011 Bulletin 2011/37**

(51) Int Cl.:
***H03F 1/32*** (2006.01)

(21) Application number: **05028756.4**

(22) Date of filing: **08.02.2001**

(54) **Variable transconductance variable gain amplifier utilizing a degenerated differential pair**

Verstärker mit variabler Transkonduktanz und variabler Verstärkung unter Verwendung einer degenerierten Differenzanordnung

Amplificateur de gain à transconductance variable utilisant une paire differentielle de contreréaction

(84) Designated Contracting States:
**DE FR GB**

(30) Priority: **15.02.2000 US 182648 P**

(43) Date of publication of application:
**19.07.2006 Bulletin 2006/29**

(62) Document number(s) of the earlier application(s) in accordance with Art. 76 EPC:
**01910559.2 / 1 260 015**

(73) Proprietor: **Broadcom Corporation
Irvine, CA 92617 (US)**

(72) Inventor: **Venes, Arnoldus
92677 Laguna Niguel, California (US)**

(74) Representative: **Jehle, Volker Armin et al
Bosch Jehle Patentanwaltsgesellschaft mbH
Flüggenstrasse 13
80639 München (DE)**

(56) References cited:
**EP-A- 0 514 655     EP-A- 0 587 965
WO-A-00/18006     JP-A- 58 154 911
JP-A- 58 204 614     US-A- 5 612 648**

- **MENSINK C H J: "A low power, low noise, variable gain amplifier" SOLID-STATE CIRCUITS CONFERENCE, 1998. ESSCIRC '98. PROCEEDINGS OF THE 24TH EUROPEAN THE HAGUE, THE NETHERLANDS 22-24 SEPT. 1998, PISCATAWAY, NJ, USA,IEEE, 22 September 1998 (1998-09-22), pages 292-295, XP010823464 ISBN: 978-2-86332-235-2**

**Description**

BACKGROUND OF THE INVENTION

Radio receivers, or tuners, are widely used in applications requiring the reception of electromagnetic energy. Applications can include broadcast receivers such as radio and television, set top boxes for cable television, receivers in local area networks, test and measurement equipment, radar receivers, air traffic control receivers, and microwave communication links among others. Transmission of the electromagnetic energy may be over a transmission line or by electromagnetic radio waves.

The design of a receiver is one of the most complex design tasks in electrical engineering. In the current state of the art, there are many design criteria that must be considered to produce a working radio receiver. Tradeoffs in the design's performance are often utilized to achieve a given objective. There are a multitude of performance characteristics that must be considered in designing the receiver.

However, certain performance characteristics are common to all receivers. Distortion and noise are two such parameters. The process of capturing the signal creates distortion that must be accounted for in the design of the radio receiver. The distortion must either be filtered out or canceled. Once a radio signal is captured, the noise surrounding the received signal in the receiver must be considered. Radio signals are often extremely weak and if noise is present in the circuit, the signal, even though satisfactorily received, can be easily lost in this noise floor. The current state of the art in receiver design is often directed to overcoming these receiver limitations in a cost effective manner.

Amplifiers are utilized to boost signal levels above the receiver noise floor. Amplification is used in many receiver functions. It is used in a fixed gain amplifier to provide a fixed gain to a signal presented to it. In providing a fixed gain a signal of a given power level presented to an amplifier is increased in power by a fixed multiplication factor. In a variable gain amplifier ("VGA") gain is often adjusted to provide an output signal of fixed power for a variety of input signal power levels. The multiplication factor is adjusted by a control depending on the power of the input signal.

Amplification is often used in conjunction with other circuit functions. Filters often incorporate amplification to boost a desired signal's level while simultaneously rejecting unwanted signals. Attenuators also incorporate amplifiers to expand their dynamic range. Thus an attenuator with gain included can produce an output signal having more or less power than a signal input to the device, depending on the setting.

Due to inherent amplifier nonlinearities the amplifiers produce distortion. Distortion tends to vary with the signal level presented to an amplifier. Strong input signals tend to increase distortion levels. Often to limit distortion the dynamic range of an amplifier is constrained to a narrow range of input signal levels to prevent distortion from arising. Constraint on signal level affects a receiver system's overall performance.

For example constraint on input levels requires tight automatic gain control ("AGC") of the receiver giving rise to further problems of stability, response time, and maintenance of the required signal level range. Amplifiers with an increased dynamic range are thus desirable in designing receivers to decrease distortion and to relax systems requirements.

SUMMARY OF THE INVENTION

A method of continuously tuning a transconductance that comprises, coupling a degeneration resistance from a first source of a first transistor in a differential pair of transistors to a second source of a second transistor in the differential pair of transistors. Applying a second variable degeneration resistance in parallel to the first degeneration resistance in response to the application of a first variable control voltage. And applying a third variable degeneration resistance in parallel to the first degeneration resistance and the second degeneration resistance in response to the application of a second variable control voltage having a fixed voltage offset from the first variable control voltage.

DESCRIPTION OF THE DRAWINGS

These and other features and advantages of the present invention will be better understood from the following detailed description read in light of the accompanying drawings, wherein:

FIG. 1 is a block diagram of a variable gain amplifier ("VGA");
FIG. 2, is a block diagram of the internal configuration of the VGA and the linearization circuit;
FIG. 3, is a graph of gain versus the control current iSig. Control current iSig is shown as a fraction of iAtten, with the total current being equal to 1, or 100%;
FIG. 4 is the schematic diagram of an embodiment of the VGA. The VGA has a control circuit to control the $V_{ds}$ of M10 and M13 at node 7505, and the $V_{ds}$ of M4 and M14 at node 7507;
FIG. 5a illustrates a family of curves showing the relationship of a transistor's drain current ("$I_d$") to its gate source voltage $V_{gs}$") measured at each of a series of drain source voltages ("$V_{ds}$") from 50 mV to 1 V;

FIG. 5b is a graph of $g_m$ verses $V_{gs}$ as $V_{ds}$ is varied from 50 mV to 1 V;

FIG. 5c is a graph of the cross-section of FIG. 78b plotting $g_m$, verses $V_{ds}$ for various values of $V_{gs}$;

FIG. 6 is a schematic of a current steering circuit;

FIG. 7a is a schematic of a VD1 control signal generation circuit.

FIG. 7b is a graph of composite transconductance vs. differential input voltage $V_{in}$ for a set of differential pair transistors coupled in parallel, and having varying degrees of offset introduced at the gates of each differential pair;

FIG. 7c is a schematic of an embodiment of a low voltage VGA. the embodiment shown of the low voltage VGA is disposed upon a semiconductor substrate;

FIG. 7d is a schematic diagram of a low voltage VGA having an increased gain range;

FIG. 7E is a block diagram of a voltage to current converter (V-I converter) having an externally controllable transconductance;

FIG. 7F is a schematic diagram of a differential amplifier having a variable transconductance;

FIG. 7G is a block diagram of a VGA circuit utilizing three amplifier stages, each stage having a variable transconductance;

FIG. 7H is a block diagram of a VGA circuit with voltage offsets introduced between the control signals coupled to amplifiers stages A1, A2, and A3;

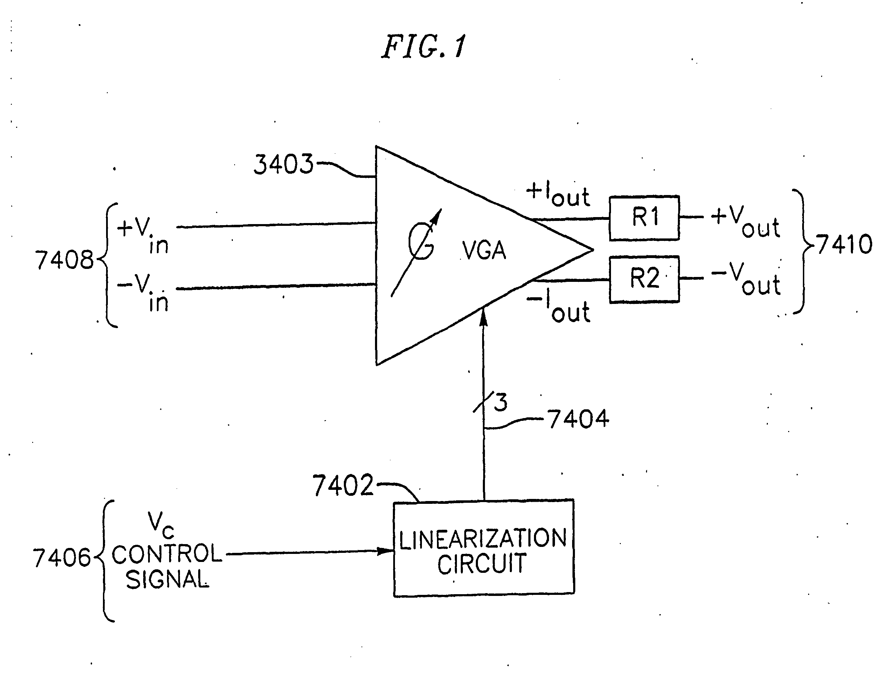

FIG. 1 is a block diagram of a variable gain amplifier ("VGA") 3403. The VGA produces a signal that is a reproduction of a signal input to it at an amplified level. The amplified levels in a VGA is capable of being varied. A variable gain is accomplished through the use of one or more control signals applied to the amplifier.

VGAs are frequnently used to maintain a constant output signal level. VGAs do this by varying the amplifier gain to compensate for varying input levels. In the case of strong or weak signals it is desirable to maintain a linear gain for input verses output signals with little noise added. Maintenance of a linear gain reduces distortion for high level input signals. VGAs are often used in IF or RF strips to compensate for prior losses or weak signal reception.

In a linear gain, a 1 dB increase in sinusoidal input signal level produces a 1 dB change in the output signal level at that same frequency. A gain of this nature is termed a "linear response." If a 1 dB change is not produced, this is indicative of an available power being diverted to produce a signal at another frequency of operation. A signal at a frequency other than desired often interferes with the signal being amplified and is termed distortion. Thus, the linearity of an amplifier is a figure of merit, the greater the linearity the better the quality of the amplifier. Amplifiers that utilize compensation circuitry and differential signal transmission tend to have improved linearity.

VGA compensation circuitry controls $V_{ds}$. For a large input signal, linearity and low gain is required. With a reduction in $V_{ds}$, good linearity and low gain are achieved. If a small signal is input to the amplifier, $V_{ds}$ is increased. The increase in $V_{ds}$ causes one or more MOSFETs internal to the VGA to be biased in the active region. Active region bias allows for high gain and low noise to be achieved simultaneously. The VGA utilizes a current steering method of applying control signals to provide an extended gain range VGA. The control of $V_{ds}$ allows the production of a linear output when a large signal is applied to the input.

The VGA has a differential input comprising two signals, $+V_{in}$ and $-V_{in}$ 7408. The VGA has a differential current output comprising two signals, $+I_{out}$ and $-I_{out}$. In the embodiment shown the differential current signals are applied to a first and second resistor R1 and R2 to produce a differential voltage output, $+V_{out}$ and $-V_{out}$ 7410 respectively. Equivalently the current outputs may be applied to work against any impedance to generate a voltage output.

A set of three control signals 7404 are supplied to the VGA 3403 from a linearization circuit 7402. The linearization circuit 7402 produces the three control signals 7404 that are derived from a single control signal, $V_c$ 7406 through compensation circuitry. Control signal $V_c$ tends to be proportional to the gain desired in the VGA 3403. The three control signals 7404 control the VGA in a manner such that a desired gain and a desired linearity tend to be produced by the VGA.

The linearization circuit is stimulated by the control signal $V_c$ 7406 is supplied by an external DSP chip. The control signal applied to the linearization circuit 7402 is shaped in a predetermined way. A goal of shaping the control circuit is to produce the second set of control signals 7404 that are applied to the VGA 3403 to produce a desired VGA gain transfer function, measured in decibels, that changes linearly with the applied control signal $V_c$. In the embodiment shown $V_c$ is a voltage, however a control circuit may be equivalently supplied. In an alternate embodiment the overall transfer function of the VGA is configured to yield a linear function of gain as measured with linear units versus control voltage by appropriately adjusting the linearization circuit through the application of a log to linear conversion current.

In addition to shaping the gain transfer function, another function of the linearization circuit is to control signals that control the VGA to produce the desired low distortion output. The second set of control signals 7404 are shown as a bussed line 7404. The second set of control signals comprise a voltage VD1 and a pair of control currents: iSig and iAtten. The second set of control signals 7404 tend to produce a linear change in gain with variation of the control signal while maintaining an acceptable distortion level in the VGA.

The three control signals are generated by two subcircuits in the linearization circuit: a current steering circuit and a drain voltage control voltage signal generation circuit. The current steering circuit produces two signals, iSig and iAtten. The drain voltage control signal voltage generation circuit produces one signal, VD1.

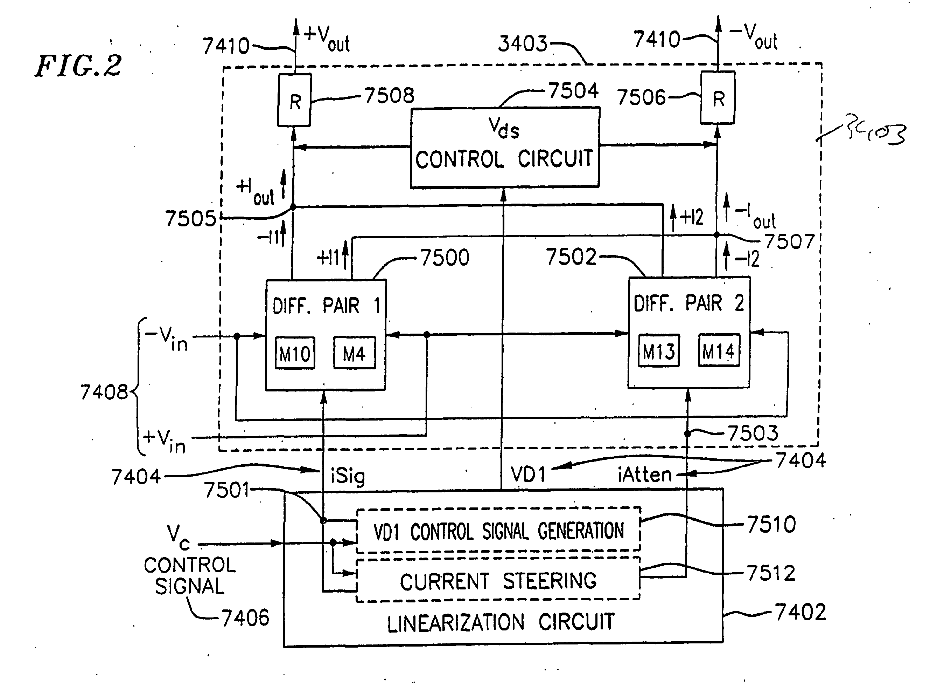

FIG. 2, is a block diagram of the internal configuration of the VGA and the linearization circuit. The VGA and linearization circuit to implement current steering and $V_{ds}$ control of the VGA are described as a separate function block. However, the functions described may be equivalently merged into the circuit functional blocks of the other.

The VGA 3403 is constructed from two cross coupled differential pair amplifiers 7500 7502. A first differential pair amplifier 7500 includes two transistors M4 and M10. A second differential pair amplifier 7502 includes transistors M13 and M14. The first and second differential pair amplifiers are driven in parallel by a differential input voltage 7408. When referenced to ground, the differential input voltage applied to each amplifier simultaneously is denoted $+V_{in}$ and $-V_{in}$.

The differential pair amplifiers have differential current outputs +I1, -I1, +I2, -I2, that are combined to produce a differential VGA output comprising $+I_{out}$ and $-I_{out}$. The first differential pair amplifier 7500 has differential current outputs +I1 and -I1 that are sinusoidal and 180 degrees out of phase from each other. The second differential pair amplifier 7502 has differential current outputs +I2 and -I2 that are sinusoidal and 180 degrees out of phase from each other. VGA output current $+I_{out}$ results from the combination at node 7505 of out of phase currents -I1 and +I2. VGA output current $-I_{out}$ results from the combination at node 7507 of out of phase currents +I1 and -I2. Note that the currents described above having a minus sign prefix, -I1, -I2, are generated in response to input voltage $-V_{in}$, and the currents with plus sign prefixes, +I1, +I2, are generated in response to $+V_{in}$.

A $V_{ds}$ control circuit 7504 within the VGA 3403 supplies a $V_{ds}$ control voltage that is applied to nodes 7505 and 7508. The $V_{ds}$ control circuit receives an input VD1 from a VD1 control signal generation circuit 7510 that is a part of the linearization circuit 7402. In alternative embodiments the $V_{ds}$ control circuit is merged into the VD 1 control signal generation circuit 751.

A current steering circuit 7512 in the gain control circuit 7402 supplies control signals iSig and iAtten. The signal iSig is a control input to the first differential pair amplifier 7500. The signal iAtten is a control input to the second differential pair amplifier 7500.

In the embodiment shown the VGA 3403 is configured to operate at an IF frequency. However it is understood that the VGA may be configured, by appropriate component selection to function at any desired frequency. In an IF strip, the addition of a VGA maintains a constant IF output as the input varies. This is accomplished by adjusting the gain of the VGA. A VGA is useful in any situation where a signal presented to a circuit is of unknown or variable strength.

Functionally the VGA maintains a constant level at its output so that subsequent circuitry may be designed that tends to have better performance and less noise. In alternate embodiments, the variable gain amplifier may be used at RF or other frequencies to reduce signal level variations in a circuit For example in an embodiment, a VGA 3403 as described may be used in the RF front end 3408 to control the RF signal level that is applied to a receiver 3402.

The overall gain of the VGA is attributable to the individual gain contributions of transistors M10 M4, M13 and M14 that produce a current gain. In an embodiment, the VGA voltage gain is set by providing resistance at the $+I_{out}$ and $-I_{out}$ terminals to establish a voltage output, and thus a voltage gain for the amplifier. The exemplary embodiment includes field effect transistors ("MOSFETs"). Equivalently, other transistor types may be substituted for the MOSFETs utilized in the exemplary embodiment. A pair of control currents iSig and iAtten and a control voltage VD1 are principally used to provide an extended range of available VGA gain and a linear in dB VGA amplifier transfer function that provides a desired linearity.

Two methods of gain control are utilized in the exemplary VGA. The first method is $V_{ds}$ control that controls noise and linearity while reducing VGA gain when large signals are applied, the second is current steering that provides an extended range of available VGA gain. The set of three control signals 7404 include iSig, iAtten and VD1.

In the first method of $V_{ds}$ control, gain and linearity in the output of the VGA tend to be controlled by adjusting each of four transistors' M4, M10, M13, M14 drain source voltages ("$V_{ds}$") of the transistors to control a transductance ("$g_m$") associated with each transistor. If a drain source voltage $V_{ds}$ across a MOSFET device M10, M4, M13, M14 is reduced, a $g_m$, transfer characteristic of that transistor, which is a function of input voltage, becomes flatter. The flatter the $g_m$ transfer function the more linearly the transistor tends to operates. The $V_{ds}$ of all four transistors is controlled in order to manipulate an overall $g_m$ characteristic for the VGA.

The $V_{ds}$ gain control method tends to reduce VGA output distortion by tending to improve the linearity of the VGA. To improve the linearity, the $V_{ds}$ of the transistors are reduced yielding better linearity in conjunction with a transistor operating point on a flattened $g_m$ curve. As an input signal's strength increases, $V_{ds}$ is reduced providing a linear response VGA. Reducing $V_{ds}$ also tends to contribute to VGA gain control. For small input signals as $V_{ds}$ is increased the MOSFETs become biased in the active region where high gain and low noise operation is obtained. The main effect of reducing $V_{ds}$ tends to be control of the linearity of the VGA amplifier.

In the second method, current steering control, currents iSig and iAtten tend to set amplifier gain over a large range. An increase in the control current iSig tends to increase gain by causing an increase in overall amplifier $g_m$, while an increase in iAtten tends to decrease gain by causing a subtraction of overall amplifier $g_m$. For certain type and size MOSFETs, the relationship between iSig, iAtten and $g_m$ is as shown in equation (14)

$$g_m = \sqrt{\frac{K}{2}}\left(\sqrt{iSig} - \sqrt{iAtten}\right) \qquad (14)$$

where

iAtten = $I_{tot}$ - Isig
K = a constant of proportionality

For other size/type transistors this relationship may not hold, but the idea is still applicable. The $g_m$S of each transistor M10, M4, M13, M14 is controlled to adjust gain. This is accomplished by subtracting, or adding currents through control lines iSig and iAtten to boost or reduce the VGA $g_m$, as required. Control signals iSig and iAtten control amplifier gain by adjusting an overall $g_m$ of the amplifier. A fixed available control current is available for controlling VGA gain through the iSig and iAtten control lines. Gain is controlled by selectively steering the available current into the appropriate control line. For large VGA signal inputs, the linearity produced in a VGA from current steering tends to be improved by the addition of the $V_{ds}$ control circuit.

A single-stage VGA amplifer with linearization circuitry as described above that utilizes current steering and $V_{ds}$ control could yield a gain control range in excess of 40 dB.

The second method of VGA gain control is $V_{ds}$ control. Linearity in amplifier output tends to be improved by $V_{ds}$ control or "$V_{ds}$ squeezing." With current steering, no provision is made for improving linearity once the input signal becomes large.

Linearity is typically determined by the $g_m$ of each of the two differential amplifier stages. The first stage comprises M10 and M4. The second stage comprises M13 and M14. The embodiment described tends to have an increased linearity of 26 dB, corresponding to a factor of 20 improvement in linearity over that typically available.

VGA operating conditions determine the distribution the currents iSig and iAtten. When a small signal is applied to the input terminals $+V_{in}$ and $-V_{in}$, it is typically desirable to amplify the signal with a high gain setting. Transistors M10 and M4 are coupled to the differential output so that their $g_m$s tend to contribute to VGA overall gain. However, transistors M 13 and M 14 are coupled to the VGA output so that their $g_m$s tend to decrease VGA gain through a $g_m$ subtraction. Transistors M4 and M10 are controlled by iSig, transistors M13 and M 14 are controlled by iAtten.

For a high gain condition, $g_m$ subtraction is undesired.

Thus, for a high gain setting, it is desirable to have most of the gain available from devices M10 and M4 contributing to the amplifier's overall gain. M10 and M4 are set for maximum gain by setting iSig to a maximum current. Correspondingly iAtten is set to a low value of current. In achieving a maximum gain, a control current is divided between iSig and iAtten such that a maximum current is present in the iSig line.

In the low gain state, the second differential pair transistors M13 and M14 are controlled by iAtten such that they subtract from the gain of M10 and M4. A large gain present for devices M13 and M14 creates a large gain subtraction in devices M10 and M4 which are controlled by iSig to produce a minimum gain.

Thus, when the signal input is small, minimum gain on M13 and M14 is desired and maximum gain on M10 and M4 is desired to produce maximum VGA gain. When the input signal is large, a maximum gain on M13 and M14 is desired and minimum gain on M10 and M4 is desired to produce minimum VGA gain.

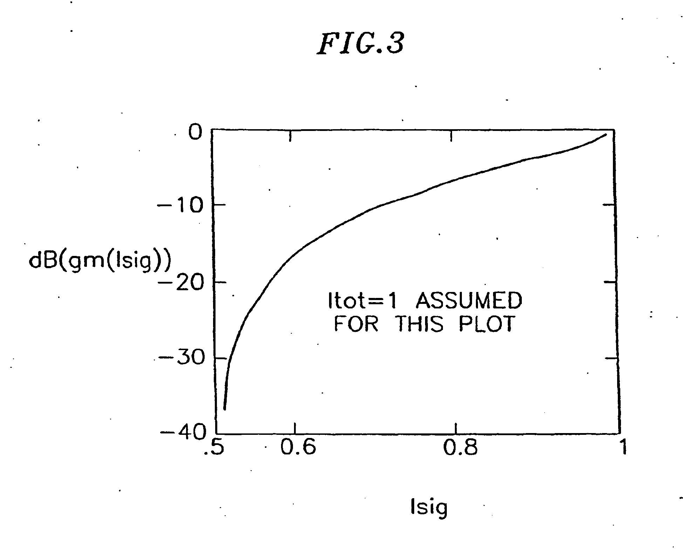

FIG. 3 is a graph of gain versus the control current iSig. Control current iSig is shown as a fraction of iAtten, with the total current being equal to 1, or 100%. At the far right of the graph, a 0 dB reference is set corresponding to maximum amplifier gain of maximum amplifier $g_m$. As iSig is reduced, control current iAtten is increasing proportionately causing the VGA's overall $g_m$ and gain to decrease.

Maximum VGA gain is desirable with a small input signal present at the VGA input. Maximum gain is achieved with a maximum current into the iSig control line and minimum current into the iAtten control line. As the signal at the VGA input becomes larger, it is desired to decrease the amplifier gain. A reduction in VGA gain is achieved by decreasing the current in the iSig line and increasing the current in the iAtten control line. A minimum VGA gain corresponds to maximum current in the iAtten control line and minimum current into the iSig line.

Returning to FIG. 2, the linearization circuit takes the externally supplied control signal 7406 that is provided as a voltage and converts it to control signals 7404 that are current and voltage signals. In the current steering circuit 7512 a maximum control signal voltage amplified in the embodiment described corresponds to a maximum gain condition with iSig set to a maximum and iAtten being set to a minimum. As the control voltage is decreased, iSig decreases and iAtten increases.

The control voltage Vc 7406 is created by digital circuitry that is responsive to the input level of the amplifier. In the embodiment described the gain control loop is closed in a digital circuitry domain located off of chip that produces control signal 7404.

The output of the VGA is sampled to determine if sufficient signal strength is available for further signal processing. The sample is processed by an A to D converter into a digital signal, and the control voltage responsive to the level of the VGA output is created. Alternatively, analog methods may be used to sample the output and generate control voltage. In an embodiment the VGA is utilized as an IF VGA. In alternate embodiments the VGA is configured for used at other frequency bands that require an adjustment in gain.

Stability of the AGC loop is maintained during changes in iSig and iAtten. Stability is achieved in the minimum gain setting by keeping iSig greater than iAtten. In the embodiment described iSig is prevented from becoming less than iAtten by the linearization circuit. If iSig becomes less than iAtten, phase inversion problems tend to occur causing a degradation in VGA performance, disrupting automatic gain control ("AGC") loop performance in a receiver. This condition is prevented from happening by providing appropriate circuitry in the linearization circuit

Also with respect to AGC loop stability, a zero gain setting is undesirable. In the embodiment, the transistors are fabricated with identical dimensions, and it is possible to set the gain equal to zero by making the iSig and iAtten currents equal. This is undesirable from a control loop stability standpoint. The linearization circuit provides appropriate circuitry preventing this condition from occurring.

Maximum attenuation is determined by how close iSig is allowed to approach iAtten in value. Thus, the maximum attenuation achieved is dependent upon the stability that is permissible as iSig approaches iAtlen.

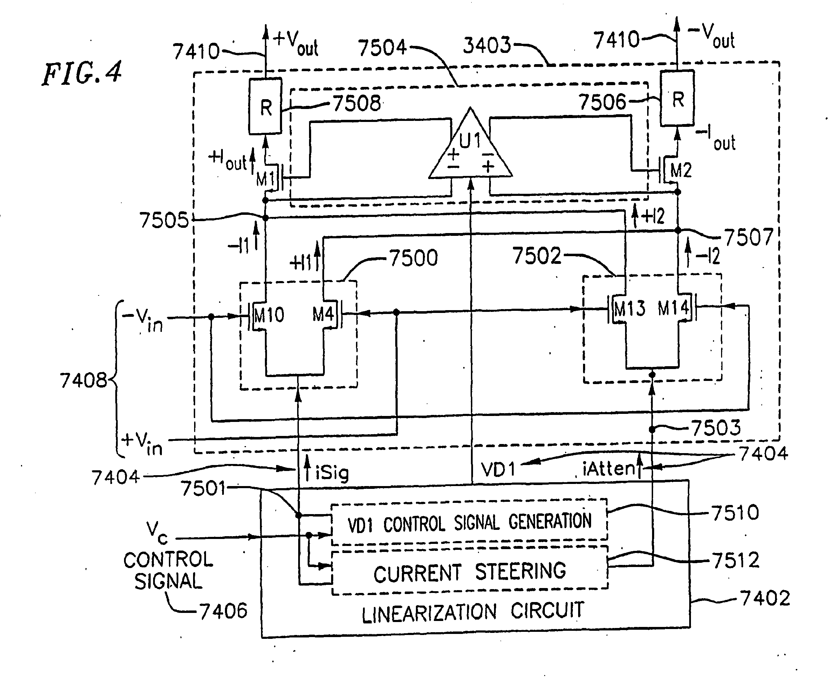

FIG. 4 is the schematic diagram of an embodiment of the VGA. The VGA has a control circuit to control the $V_{ds}$ of M10 and M13 at node 7505, and the $V_{ds}$ of M4 and M14 at node 7507.

A control voltage VD1 is generated by the linearization circuit 7510 and applied to control a differential amplifier U1. The negative input of U1 is coupled to node 7505; and the positive input of U1 is coupled to node 7507.

A transistor M1 has its source coupled to node 7505, its drain comprises the $+I_{out}$ terminal of the VGA. The gate of transistor M1 is coupled to the positive output of U1. A transistor M2 has its source coupled to node 7507, its drain comprises the $-I_{out}$ terminal of the VGA. The gate of transistor M2 is coupled to the negative output of A1.

The $V_{ds}$ squeezing is utilized since it tends to improve linearity. As the control signal voltage increases, the control voltage VD1 decreases tending to decrease the VGA gain. As previously discussed, iSig is decreasing and iAtten is increasing to achieve the desired decrease in VGA gain. Concurrently with $V_{ds}$ squeezing, the $V_{ds}$ of all four transistors M10, M4, M13, M 14 also tends to decrease with increasing input signal level due to the application of a variable DC voltage at the transistor source leads. A DC voltage is fixed at nodes 7501 and 7503. Thus, the way available to reduce $V_{ds}$ for M10, M4, M13, and M14 is to reduce the DC voltage at the $+I_{out}$ and $-I_{out}$ terminals. A variable voltage source is connected at each node $+I_{out}$, and $-I_{out}$ - 7505, 7507.

The sources of M13 and M14 are coupled in common to node 7503 and to the control signal iAtten. Control signal iAtten tends to cause a decrease in amplifier gain, while control signal iSig tends to increase amplifier gain. The sources of M10 and M4 are coupled in common to iSig at node 7510. The drains of M10 and M13 are coupled in common to provide an output signal $+I_{out}$. The drains of M4 and M14 are coupled in common to provide an output signal $-I_{out}$. In the exemplary embodiment input $-V_{in}$ is coupled to the gates of M10 and M14. Input $+V_{in}$ is coupled to the gates of M4 and M13. In the exemplary embodiment differential inputs and outputs are shown in the amplifier. However, it is understood by those skilled in the art that a single ended configuration is equivalently produced by the use of a device such as a balun.

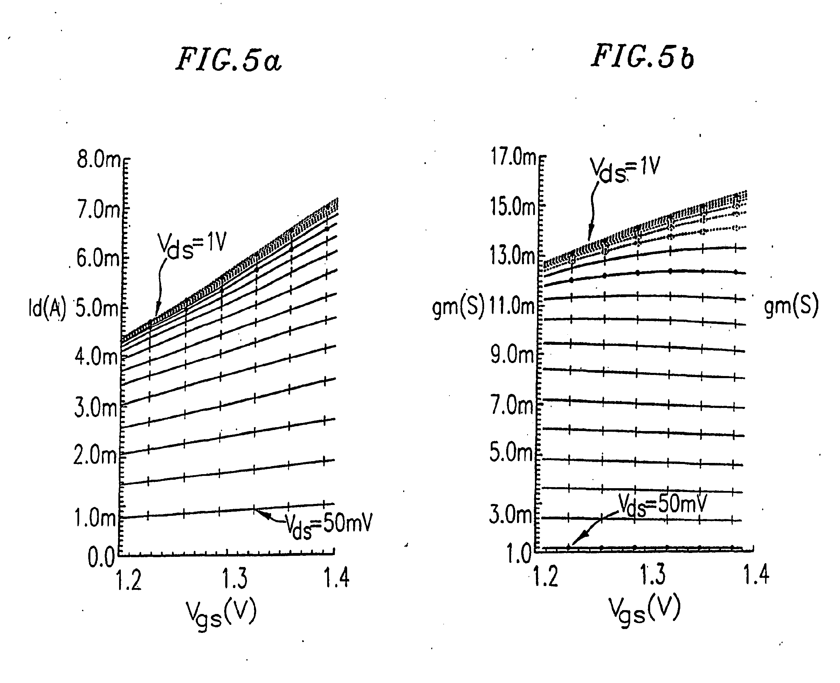

FIG. 5a illustrates a family of curves showing the relationship of a transistor's drain current ("$I_d$") to its gate source voltage ("$V_{gs}$") measured at each of a series of drain source voltages ("$V_{ds}$") from 50 mV to 1 V. From this graph a transconductance, $g_m$ is determined. The following relationship defines a $g_m$, curve for each $V_{ds}$ value:

$$g_m = dI_d \setminus dV_{gs} \qquad\qquad (15)$$

FIG. 5b is a graph of $g_m$ verses $V_{gs}$ as $V_{ds}$ is varied from 50 mV to 1 V. To provide improved output linearity performance, it is desirable to operate a transistor on a curve of $g_m$ that has a constant value and zero slope. As seen in the graph for a $V_{ds}$ of approximately 50 mV, the curves of $g_m$ verses $V_{gs}$ tend to be flat. As $V_{ds}$ is increased, the curve begins to slope, indicating the presence of non-linearity in the output signal. As $V_{ds}$ increases the curve not only begins to slope, but it develops a bow, further complicating the compensation for the non linearities at the higher level of $V_{ds}$. These irregularities in $g_m$ tend to be the sources of non-linearities in the output of the amplifier. Thus, it is desired to provide a flat $g_m$ response to produce a more linear transfer function for the VGA by controlling $V_{ds}$.

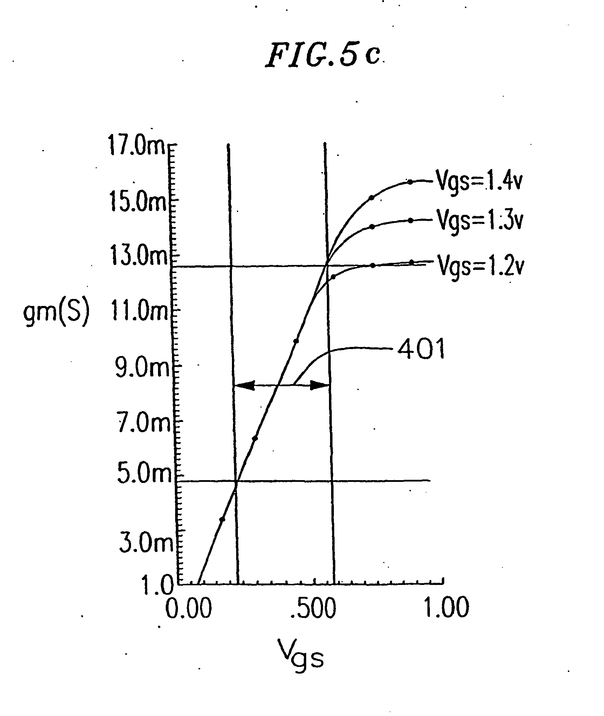

FIG. 5c is a graph of the cross-section of FIG. 5b plotting $g_m$ verses $V_{ds}$ for various values of $V_{gs}$. As $V_{ds}$ changes from approximately 200 mV to 500 mV, $g_m$ changes from approximately 5 mS to 13 mS. The change in $g_m$ from 5 mS to 13 mS by changing $V_{ds}$ may be used to control gain. Thus, as $V_{ds}$ is decreased, the gain is decreased. Control of $V_{ds}$ provides approximately 9 dB of gain control range.

Within the range of $V_{ds}$, graphed between the vertical bars 7801, the value for $g_m$ remains essentially the same for a range of $V_{gs}$ input signal from 1.2 V to 1.4 V. Thus by controlling $V_{ds}$ from 200 mV to 600 mV approximately 9 dB of gain control is provided.

When control of $V_{ds}$ is is combined with the $g_m$ subtraction method previously described, the linear output signal is maintained. In addition approximately 8 dB to 9 dB of gain control in addition to that provided by $g_m$ subtraction contributes to provide overall VGA gain control on the order of 30 dB, in the exemplary embodiment.

Output linearity is often quantitized by measuring an intermodulation product produced by two input signals present at differing frequencies For the VGA a two tone intermodulation ("IM") product test is utilized, and the distortion as represented by the third order intermodulation product is measured. Approximately a 26 dB decrease in the third order IM product tends to be achieved in the exemplary embodiment.

With the input signal maintained at a constant level, the output signal at $+I_{out}$ and $-I_{out}$ is measured as gain squeezing is performed. Improvement is measured as compared to adjusting gain without utilizing gain squeezing. A reduction in third order intermodulation of approximately 25 dB is measured as $V_{ds}$ is squeezed within a range of approximately 150 mV to 200 mV. Utilizing a test having two tones at 44 MHZ and 45 MHZ typically produces third order intermodulation product components at 43 MHZ and 46 MHZ. With this test, 20 dB to 25 dB improvement in third order intermodulation is observed in the exemplary embodiment. A typical improvement of 20 dB is realized in the linearity of the output signal.

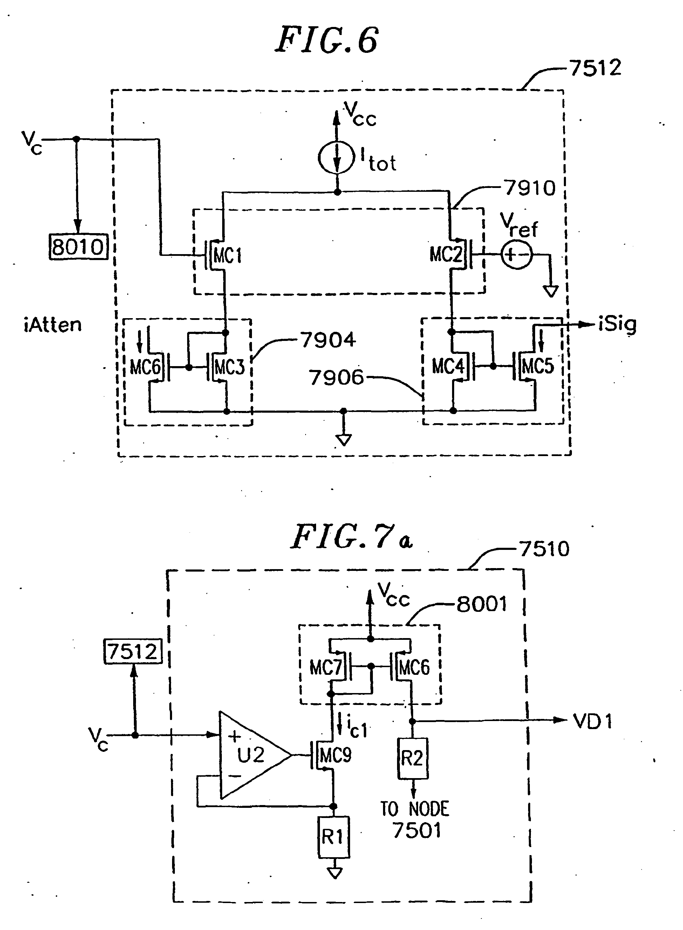

FIG. 6 is a schematic of a current steering circuit. An external control signal $V_c$ drives a differential pair amplifier 7910 including MC1, MC2, to ultimately generate iSig and iAtten. The iSig and iAtten are generated through two current mirrors 7904, 7906. The first current mirror 7904 comprises MC3 and MC6. The second current mirror 7906 comprises MC4 and MC5. The circuit maintains a fixed relationship between iSig and iAtten, defined by:

$$I_{tot} = iSig + iAtten \tag{16}$$

To guarantee that phase reversal does not occur, iSig must remain greater than iAtten at all times. By selecting $V_{ref}$ to be slightly less than the <u>minimum</u> value of control voltage $V_c$ that will be present, iSig will remain greater than iAtten.

In an embodiment of current steering circuit 7512, a control voltage $V_c$ is applied to a differential pair amplifier 7910. In the exemplary embodiment, control signal $V_c$ ranges from 0.5 V to 2.5 V. The 0.5 V corresponds to a minimum gain setting and 2.5 V corresponds to a maximum gain setting. Differential pair amplifier 7910 comprises two transistors MC1 and MC2. In the exemplary embodiment, field effect transistors are used. Equivalently, other types of transistors may be substituted for field effect devices. The inputs to the differential pair amplifier are the gates of MC1 and MC2. The sources of MC1 and MC2 are coupled in common to a current source $I_{tot}$. Current source $I_{tot}$ is in turn coupled to a supply voltage $V_{cc}$. Current source $I_{tot}$ is conventional current source constructed as is known by those skilled in the art.

The drains of MC1 and MC2 are coupled to current mirrors 7904 and 7906, respectively. Control voltage $V_c$ is coupled to the gate of MC1 and a voltage reference is coupled to the gate of MC2. Voltage reference $V_{ref}$ is typically constructed as conventional voltage source know to those skilled in the art. The currents present in the sources of MC1 and MC2 drive current mirrors 7904 and 7906, respectively. Current mirror 7904 comprises transistors MC6 and MC3. Current mirror 7906 comprises transistors MC4 and MC5. These current mirrors are constructed conventionally as is know by those skilled in the art. Output of current mirror 7904 and 7906 consists of the control signals iAtten and iSig.

FIG. 7a is a schematic of a VD1 control signal generation circuit Control signal $V_c$ is fed to the positive input of a differential amplifier U2. Signal ended output of amplifier U2 is fed into the gate of transistor MC9. The source of MC9 is connected to the negative input of U2. The source of MC9 is also coupled to a first terminal of a resistor R1. A second terminal of R1 is coupled to ground. The drain of MC9 receives a current $i_{cl}$ that is supplied by a drain of transistor MC7. The drain of MC7 is coupled to the gate of MC7. The source of MC7 is coupled to a supply voltage $V_{cc}$. The gate of MC7 is coupled to the gate of MC6. The source of MC6 is coupled to a supply voltage $V_{cc}$. The drain of MC6 is coupled to a first terminal of a resistor R2. The second terminal of resistor R2 is coupled to node 1001. The node formed by coupling MC6 to R2 supplies control signal VD1. Together transistors MC7 and MC6 form a current mirror 8001.

Control current $V_c$ sets up the control current $i_{cl}$ through amplifier U2, resistor R1 and transistor MC9. Current $i_{cl}$ is mirrored through transistor MC7 and MC8 of the current mirror. The current generated in the drain lead of MC6 creates a voltage across resistor R2 as reference to the voltage present on node 7501. Thus, R1 and R2 are sized properly to control $V_{ds}$ across M10, M4, M13 and M14. For example, VD1 can range from 100 mV to 600 mV. This condition corresponds to a $V_c = 05V$ at a minimum gain maximum input condition and a $V_c = 2.5V$ maximum gain minimum input signal condition.

In alternative embodiments, control voltage $V_c$ may be subjected to conditioning by temperature compensation circuitry and linear in dB transfer function compensation before being applied to the VD1 generation circuit 7510.

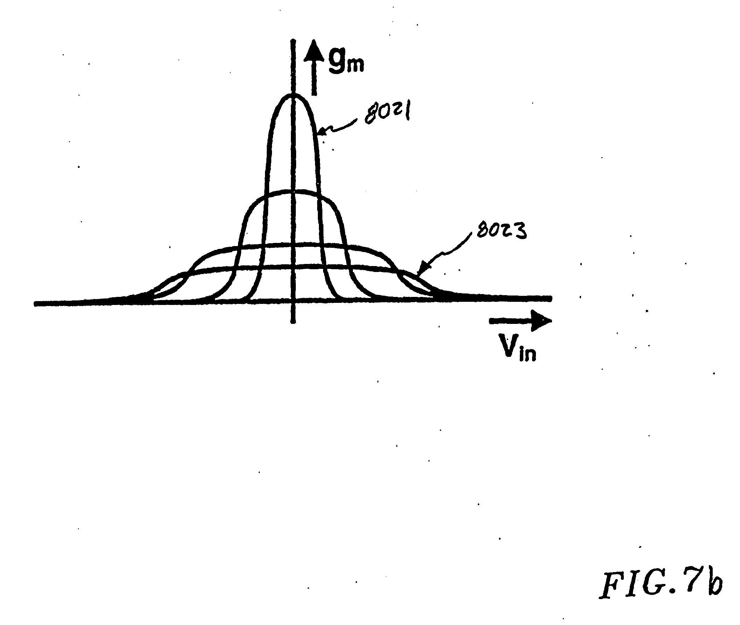

FIG. 7b is a graph of composite transconductance vs. differential input voltage $V_{in}$ for a set of differential pair transistors coupled in parallel, and having varying degrees of offset introduced at the gates of each differential pair. The offsets are typically created by coupling the gates of differential pair transistors to nodes in a resistive ladder and applying a variable voltage across the ladder, to change the voltage difference between nodes.

For the case of an input voltage of "0" volts, no current flows through resistive ladders. Thus, all the gates of the individual differential pairs are at zero volts DC. At zero volts input the maximum gain shown by curve 8021 is achieved. However, the range of voltages over which this gain is achievable tends to be small.

As the currents in the ladders are increased a greater offset is generated between the parallel coupled differential pairs resulting in a transconductance curve 8023 that possesses a lower gain. However this gain is available over a larger range of input voltages. Thus, a larger linear input window is provided.

If the signal input is not kept separate from the control signal typically imposed upon a ladder circuit VGA performance tends to degrade at high frequencies if the RF impedance of the ladder circuits 8009, 8011 is not kept low. However, if both a control signal and an input signal are both applied to the resistor ladders, a low RF impedance in the ladder means that more DC current tends to flow in the ladder causing an increased power dissipation in the reference ladder.

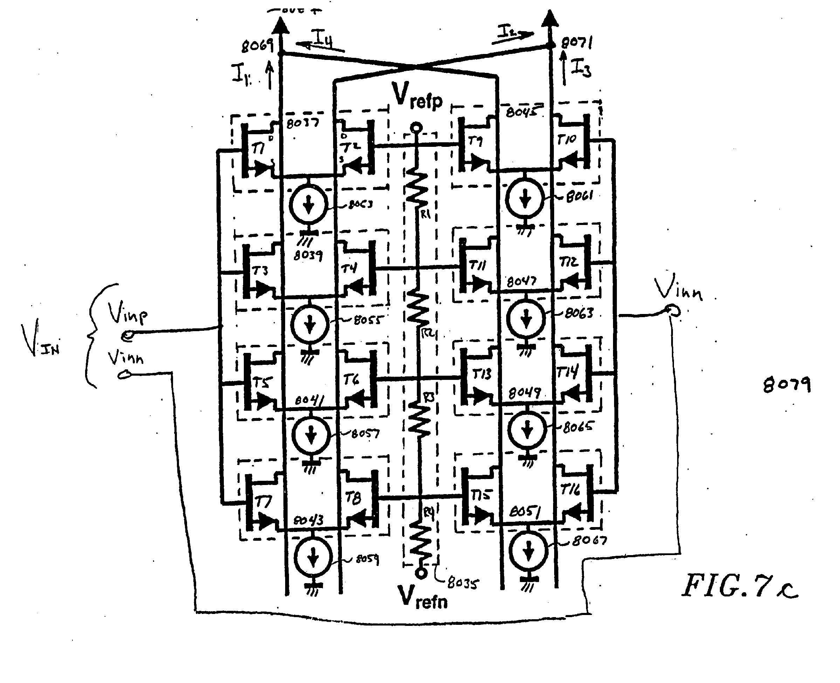

FIG. 7c is a schematic of an embodiment of a low voltage VGA. the embodiment shown of the low voltage VGA is disposed upon a semiconductor substrate 8079. Typical substrates include silicon fabricated by a CMOS process. In the embodiment shown of a low voltage VGA, a pair of amplifiers are cross coupled in parallel. In the low voltage VGA, performance tends to be better than that of a multiple differential pair amplifier when it is operated under low supply voltage conditions.

In a typical design approach, DC bias voltages are applied at the same pins as the AC signal voltages. AC inputs to the transistors typically have resistors of the reference ladders disposed between the gates and the voltage source of the signal. The typical design approach is usually not desirable when input voltages tend to be less than two and a half volts..

In the low voltage VGA of the present invention a reference ladder is disposed such that its DC signal path has been separated from that of the AC input signal path. Thus, the DC input drop is not present in the AC signal input lines.

In the embodiment shown, a first set of differential pairs 8037, 8039, 8041, 8043 is cross-coupled to a second set of differential pairs, 8045, 8047, 8049, 8051. A single resistive ladder 8035 is utilized to spread the VGA transconductance evenly over a range of input voltages. In the embodiment shown, the differential input voltage $V_{IN}$ is not applied to the same transistor gates as the reference voltages $V_{REFP}$, $V_{REFN}$. Thus, the input voltage is decoupled from the input signal and the reference ladder voltages apply to the gates of the various differential pairs remain static. Decoupling of the input signal from the reference voltages allows a significant power dissipation reduction.

In the embodiment shown, a differential input voltage $V_{IN}$ includes a positive component $V_{INP}$, and a negative component $V_{INN}$. The output of the VGA, $I_{OUT}$ is a differential signal comprising $IOUT_{OUT+}$, $I_{OUT}$. The positive output signal $I_{OUT+}$ includes the sum of two currents $I_1$ and $I_4$. The negative output current $I_{OUT}$. includes currents $I_2$ and $I_3$. A control voltage ($V_{REFP}$. $V_{REFN}$) is applied across the reference ladder 8035.

The reference ladder 8053 includes a first terminal of resistor R1 coupled to voltage $V_{REFP}$. A second terminal of R1 coupled to a first terminal of R2, a second terminal of R2 coupled to a first terminal of R3, a second terminal of R3 coupled to a first terminal of R4, and a second terminal of R4 coupled to voltage $V_{REFN}$. Input voltage $V_{INP}$ is simultaneously coupled to the gates of transistors T1, T3, T5, and T7 of respective differential pairs 8037, 8039, 8041, and 8043. The voltage $V_{INN}$ is simultaneously coupled to the gates of transistors T10, T12, T14, and T16 of respective differential pairs 8045, 8047, 8049, and 8051. The gates of transistors T2 and T9 are coupled to the first terminal of resistor R1. The gates of transistors T4 and T11 are coupled to the node formed by the coupling of the second terminal of R1 and the first terminal of R2. The gates of transistors T6 and T13 are coupled to the node formed by the coupling of the second terminal of R2 to the first terminal of R3. The gates of T8 and T15 are coupled to the node formed by the second terminal of resistor R3 coupled to the first terminal of resistor R4.

At node 8069, currents $I_1$ and $I_4$ combine to form current $I_{OUT+}$ flowing out of node 8069. The drains of transistors T1, T3, T5, and T7 are coupled to node 8069. The drains of transistors T9, T11, T13, and T15 are coupled together to form current $I_4$ which is coupled to node 8069.

Node 8071 is formed by the intersection of lines carrying currents $I_2$ and $I_3$. The current falling out of node 8071 is $I_{OUT}$. The drains of transistors T10, T12, T14, and T16, are coupled together to form current $I_3$, which flows into node 8071. The drains of transistors T2, T4, T6, and T8 are coupled together to form current $I_2$ flowing into node 8071.

The sources of transistors T1 and T2 are coupled together and in turn coupled to a first terminal of conventionally constructed current source 8053. A second terminal of conventionally constructed current source 8053 is coupled to ground. The sources of transistors T3 and T4 are coupled together and in turn, coupled to a first terminal of conventionally constructed current source 8055. A second terminal of conventionally constructed current source 8055 is coupled to ground. The source terminals of transistors T5 and T6 are coupled together and in turn coupled to a first terminal of conventionally constructed current source 8057. A second terminal of conventionally constructed current source 8057 is coupled to ground. The sources of transistors T7 and T8 are coupled together and in turn coupled to a first terminal of conventionally constructed current source 8059. A second terminal of conventionally constructed current source 8059 is coupled to ground.

The source terminals of transistors T9 and T10 are coupled together and in turn, coupled to a first terminal of conventionally constructed current source 8061. A second terminal of conventionally constructed current source 8061 is coupled to ground. The source terminals of transistors T11 and T12 are coupled together and in turn coupled to a first terminal of conventionally constructed current source 8063. A second terminal of conventionally constructed current source 8063 is coupled to ground. The source terminals of transistors T13 and T14 are coupled together and in turn coupled to a first terminal of conventionally constructed current source 8065. A second terminal of conventionally constructed current source 8065 is coupled to ground. The source terminals of transistors T15 and T16 are coupled together and in turn coupled to a first terminal of conventionally constructed current source 8067. A second terminal of conventionally constructed current source 8067 is coupled to ground.

In the embodiments shown, transistors T1, T2, T3, T4, T5, T6, T7, T8, T9, T10, T11, T12, T13, T14, T15, and T16 are NMOS devices. In an alternative embodiment, Pmoss transistors may be utilized equivalently.

The low voltage VGA includes a first differential pair of transistors 8037 comprising transistors T1 and T2; a second differential pair of transistors 8039 comprising transistors T3 and T4; a third differential pair of transistors 8041 comprising transistors T5 and T6; a fourth differential pair of transistors 8043 comprising transistors T7 and T8; a fifth differential pair of transistors 8045 comprising transistors T9 and T10; a sixth differential pair of transistors 8047 comprising transistors T11 and T12; a seventh differential pair of transistors 8049 comprising transistors T 13 and T 14; An eighth differential pair of transistors 8051 comprising transistors T15 and T16. In an alternative embodiment, a different even number of differential pairs may be utilized to construct a low voltage VGA.

To ensure proper operation, i.e., a maximum linear input window, a common node level of analog input signal at $V_{IN}$ should be biased about the middle tap of the voltage reference ladder between $V_{REFP}$ and $V_{REFN}$, This is accomplished using a resistive connection between the middle tap of the reference ladder and the two input terminals, using an AC coupling capacitor between the input terminals and the common input gate.

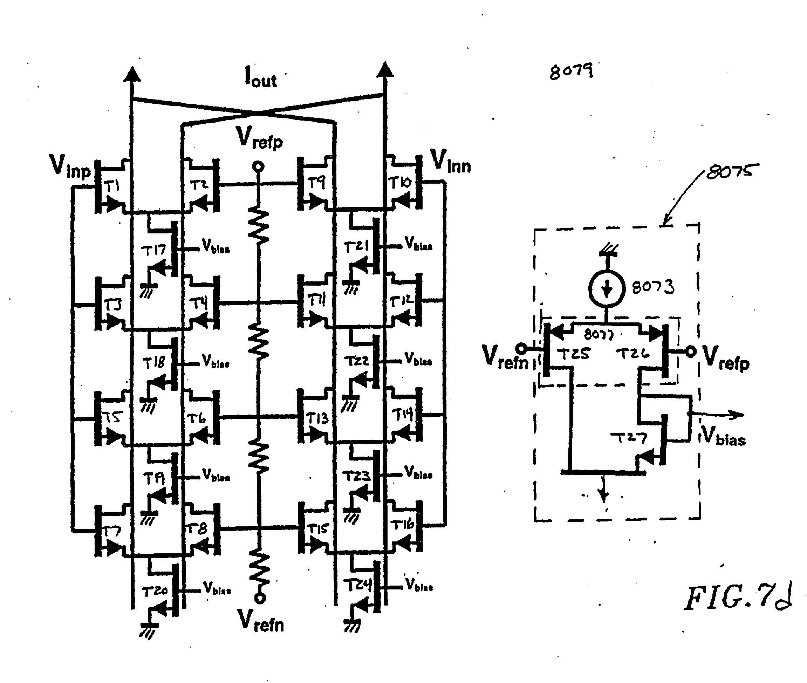

FIG. 7d is a schematic diagram of a low voltage VGA having an increased gain range. The gain range of the low voltage VGA is typically increased by modulating tail currents of the differential pairs as a function of the control voltage ($V_{REFP}$ - $V_{REFN}$). This circuit implementation is achieved by adding a tail current modulation circuit 8075 and reproducing the circuit of FIG. 7c with the current sources replaced by NMOS transistors.

In each instance, an NMOS transistor is coupled to the sources of a differential pair, and the source of the transistor (e.g. T17) replacing the conventional current source is coupled to ground. The gates of the transistors replacing the conventional current sources are all tied in common to a voltage $V_{BIAS}$.

The tail current modulation circuit 8075 includes a conventional current source 8073 having a first terminal coupled to ground and a second terminal coupled to the source terminals of a differential pair of PMOS transistors 8077 including PMOS transistors include PMOS transistor T25 and T26. The drain of T25 is coupled to a source terminal of a transistor T27. The drain terminal of T26 is coupled to a drain terminal of transistor T27. The source of transistor T27 is coupled to a supply voltage. The gate of transistor T27 is coupled to its drain and forms the voltage $V_{BIAS}$. Transistor T27 is a conventional NMOS transistor. Voltage $V_{REFN}$ is coupled to the gate of transistor T25. The voltage $V_{REFP}$ is coupled to the gate of transistor $T_{26}$.

In the embodiments described, power dissipation in the referenced ladders is typically reduced significantly compared to that available in the prior art. In addition, the minimum power supply voltage requirement for this embodiment is reduced. Reduction of the power supply voltage requirement facilitates the usefulness of VGA circuits disposed in deep submicron CMOS processes.

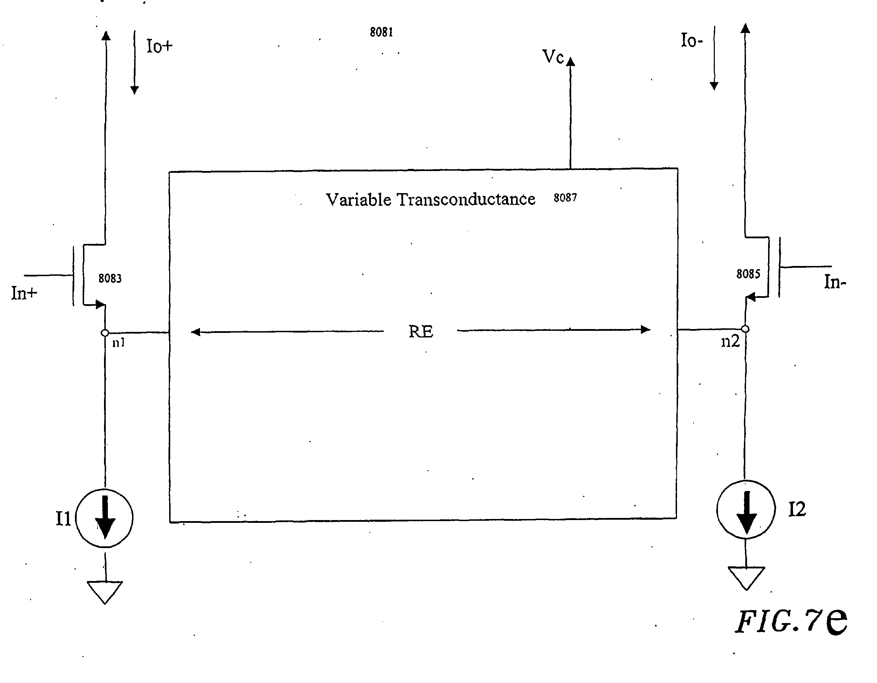

FIG. 7E is a block diagram of a voltage to current converter (V-I converter) having an externally controllable transconductance 8087. A degenerated differential pair of transistors has a degeneration resistance that is controlled through a control voltage signal Vc. The configuration shown is typically utilized in a variable gain amplifier. However, the degenerated differential pair amplifier may be utilized in any circuit where a variable transconductance tends to be advantageous.

In addition the circuit tends to possess a linear transfer function of voltage out, verses voltage in such that the circuit tends to behave as a voltage to current, or V-I, converter. The variable transconductance provided by degenerated differential pair amplifier is an alternative embodiment to the multiple differential pair amplifiers previously described (as shown in FIG. 7c and FIG 7d).

The differential pair amplifier includes transistors 8083 and 8085. In the embodiment shown, transistors 8083 and 8085 are shown as field effect transistors, however, in alternative embodiments other types of transistors may be equivalently substituted. The input to the differential pair amplifier comprises a differential input signal at the input terminals of the differential amplifier In+, In-. The differential pair amplifier has a differential current output comprising output currents Io+ and Io-. In alternative embodiments a differential output voltage may be supplied by disposing resistors in series with the output signals. A differential amplifier comprising transistors 8083 and 8085 is typically disposed on an integrated circuit substrate 8081. In the embodiment shown, the substrate is silicon having the circuit disposed upon it, and fabricated utilizing conventional CMOS processing.

The differential pair amplifier includes the input signal In+ coupled to a gate terminal of transistor 8083. The drain of transistor 8083 is coupled to output signal Io+. The source of transistor 8083 forms a node n 1 that is coupled to a first terminal of conventionally constructed current source I1. In the embodiment shown current source I1 includes a second terminal coupled to ground. However, in an alternative embodiment utilizing PMOS transistors a connection to ground is unnecessary.

Transistor 8085 includes a gate connection coupled to input In-. Transistor 8085 includes a drain connection coupled to output signal Io-. Transistor 8085 includes a source connection defined by node n2 coupled to a first terminal of a conventionally constructed current source 12. Current source I2 includes a second terminal coupled to ground. However, in an alternative embodiment utilizing PMOS transistors a connection to ground is unnecessary. In the embodiment shown, the current supplied by current source I1 is equal to the current supplied by current source I2.

A variable impedance circuit 8087 is coupled from node n1 to node n2. The impedance looking into the variable impedance circuit 8087 across nodes n1 and n2 is equal to RE. RE is related to the differential pair amplifier transconductance by the relation:

$$g_m = \frac{GM'}{1 + GM'\left(\dfrac{RE}{2}\right)}$$

where GM' is the transconductance of transistors 8083 and 8085.

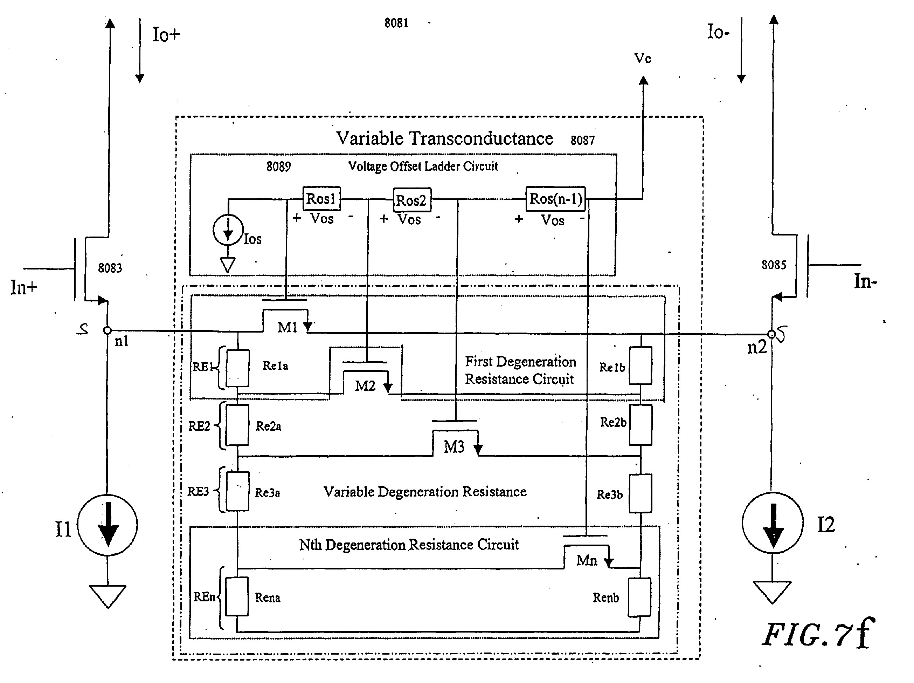

FIG. 7F is a schematic diagram of a differential amplifier having a variable transconductance. The connection of the differential amplifier having transistors 8083 and 8085 to a variable impedance circuit 8087 is as previously described in FIG. 7E. Variable impedance circuit 8087 includes a conventionally constructed current source Ios having a first terminal coupled to ground. However, in an alternative embodiment utilizing PMOS transistors a connection to ground is unnecessary. Current source Ios includes a second terminal coupled to a first terminal of a voltage offset ladder circuit 8089. Voltage ladder circuit 8089 includes a second terminal coupled to an externally supplied variable control voltage $V_c$. In an alternative embodiment control voltage Vc is a constant voltage.

The first terminal of voltage offset ladder circuit 8089 is coupled to a first terminal of an offset resistor Ros1. Resistor Ros1 includes a second terminal coupled to a first terminal of a second offset resistor Ros2. Offset resistor Ros2 includes a second terminal coupled to a first terminal of the subsequent offset resistor Ros(n-1). Subsequent offset resistor Ros(n-1) includes a second terminal that forms the second terminal of the voltage offset ladder circuit that is supplied by controlled voltage Vc. The first terminal of offset resistor Ros1 is coupled to a gate of a transistor M1. The first terminal of offset resistor Ros2 is coupled to a gate of a transistor M2. The second terminal of offset resistor Ros2 is coupled to a gate of a transistor M3. The second terminal of offset resistor Ros(n-1) is coupled to a gate of a transistor Mn.

Transistor M1 includes a drain coupled to node n1, and a source coupled to node n2. The drain of transistor M1 is coupled to a first terminal of resistor Re1a. A second terminal of resistor Re1a is coupled to a first terminal of resistor Re2a. Resistor Re2a includes a second terminal coupled to a first terminal of resistor Re3a. Resistor Re3a includes a second terminal coupled to a first terminal of a subsequent resistor Rena. Resistor Rena includes a second terminal coupled to a second terminal of a subsequent resistor Renb. The subsequent resistors are an indication that multiple resistors are utilized in alternative embodiments of the circuit shown.

The source of transistor M1 is coupled to a first terminal of a resistor Re1b. A second terminal of resistor Re1b is coupled to a first terminal of a resistor Re2b. A second terminal of resistor Re2b is coupled to a first terminal of resistor Re3b. A second terminal of resistor Re3b is coupled to a first terminal of the subsequent resistor Renb.

A drain of transistor M2 is coupled to the second terminal of resistor Re1a. A source terminal of transistor M2 is coupled to a second terminal of resistor Re1b. A drain of transistor M3 is coupled to a second terminal of resistor Re2a. A source of transistor M3 is coupled to the second terminal of resistor Re2b. A drain terminal of transistor Mn is coupled to the first terminal of the resistor Rena. A source of terminal of transistor Mn is coupled to the first terminal of the resistor Renb.

RE is the equivalent impedance from node n1 to n2. By varying RE, $g_m$ is varied, and ultimately the amplifier gain. In the minimum gain ($g_m$) mode, as shown by curve 8023 of FIG. 7B, all the transistor switches M1, M2, M3, ... Mn are off. Transistors M1, M2, M3,..... are utilized to provide a controlled transconductance. A controlled transconductance is provided by operating the transistors in a mode other than a hard on or off state. In an intermediate state the channel resistance tends to vary, contributing to the resistance being switched into the circuit. With all switches off, RE = Rela+Re2a+ ...+Rena+Re1b+Re2b+...+Renb. For maximum gain ($g_m$) all transistor switches M1, M2, M3, ... Mn are on.

In the maximum gain mode, RE = Ron/n. Ron is the on impedance, or resistance, of each transistor switch when it is biased to the on state. In an alternative embodiment RE does not have to be a parallel combination of equal valued resistors. The individual resistors making up RE may be of differing values to provide differing degrees of degeneration resistance control. In the embodiment shown, the Ron of each switch is activated at different times due to the gate biasing offsets introduced by the voltage offset ladder circuit 8089.

Intermediate gain ($g_m$) modes are possible by varying control voltage Vc. As Vc increases, the transistor switches having the least resistance in series with their gates and Vc are turned on first. For example, transistor Mn is typically turned on first followed by transistor M3, then M2, and then finally M1. Turning on the transistor switches one by one tends to shunt resistance first formed by the various resistor pairs, Rena and Renb, then Re3a and Re3b, then Re2a and Re2b and finally Re1a and Re1b. Thus the effective impedance, RE is reduced.

The voltage offset ladder circuit 8089 includes a current source Ios and resistors Ros1 through Ros(n-1). In the embodiment shown, resistors Ros1 through Rosn are equal in value. The resistors, stimulated by the current source Ios, generate offset voltages Vos. In the embodiment shown, Vos is set to provide sufficient staggering in the turnon of the transistor switches. By staggering the turnon of the transistor switches, M1 through Mn, the distortion response of the amplifier is improved and a linear gain in decibels tends to be produced. Various numbers of sections RE1, RE2, RE3, ... REN each comprising a transistor switch M1, M2, M3 ... Mn and a pair of resistors Re1a, Re1b; Re2a, Re2b; Re3a, Re3b; ... Rena and Renb respectively. In alternative embodiments increasing the number of segments tends to improve the linearity of the control characteristic.

Returning to FIG. 7B, when an input signal is large, the input voltage range $V_{in}$ is allowed to widen 8023 tending to improve distortion characteristics at a low gain setting. When the VGA is presented with a small input signal, $V_{in}$ high amplification tends to be needed. In the high gain mode, the input voltage range $V_{in}$ is reduced 8021. However, distortion performance tends to be unaffected since the input voltage amplitude is also proportionately reduced.

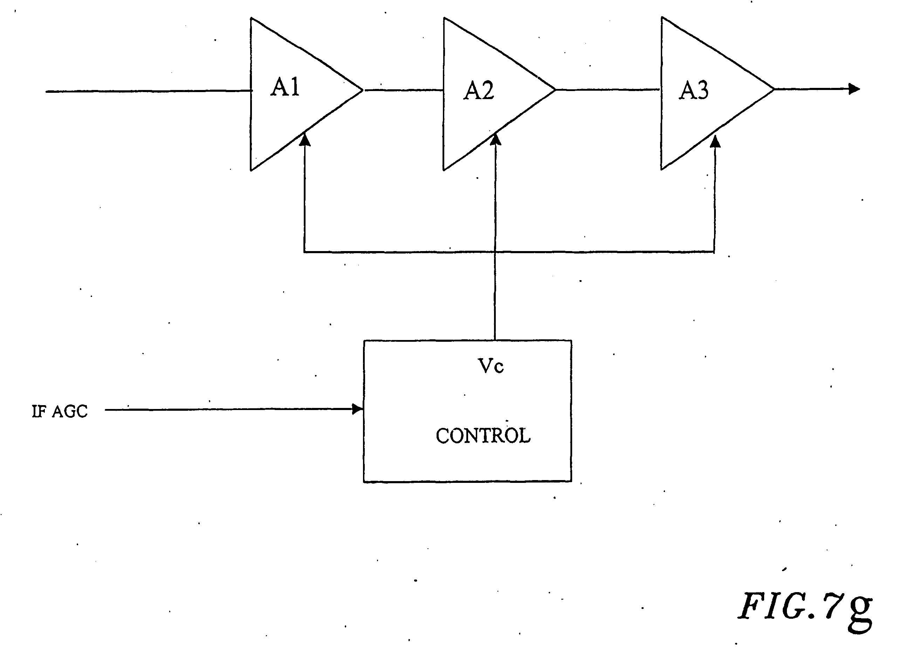

FIG. 7G is a block diagram of a VGA circuit utilizing three amplifier stages, each stage having a variable transconductance. An input signal is applied to a first amplifier input A1. The output of amplifier A1 is applied to an input of an amplifier A2. The output of amplifier A2 is in turn applied to the input of an amplifier A3. An output of A3 is typically coupled to subsequent signal processing circuitry; such as an AD converter. A control voltage Vc originating from a control block is simultaneously applied to control voltage inputs of amplifiers A1 A2, and A3. Control voltage Vc is derived from an AGC control voltage.

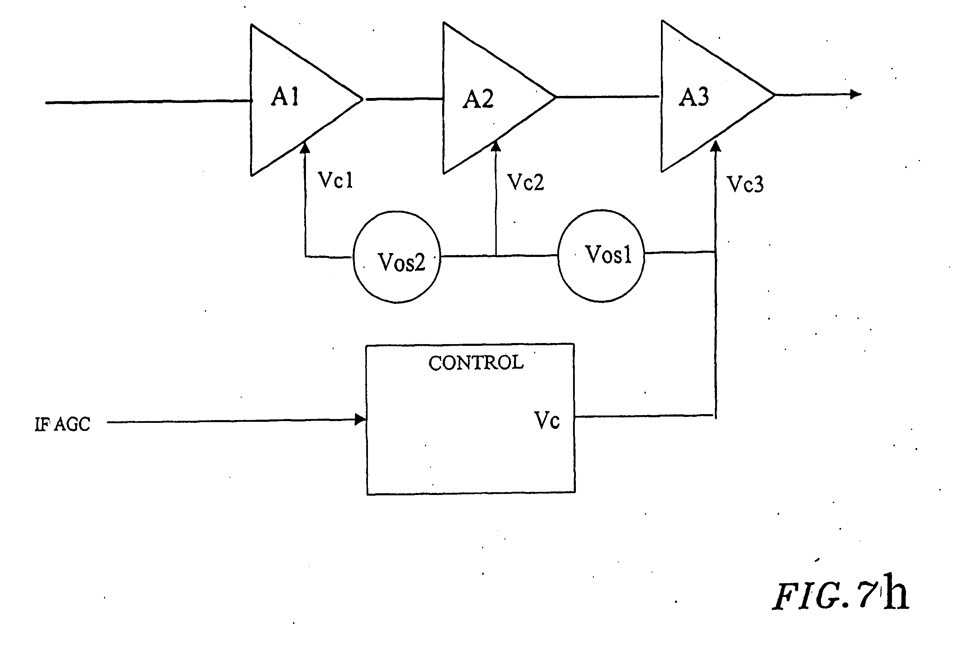

FIG. 7H is a block diagram of a VGA circuit with voltage offsets introduced between the control signals coupled to amplifiers stages A1, A2, and A3. Thus a different control voltage is generated for each of the three stages. In the embodiment shown, an input signal is applied to an amplifier A1 having an output applied to the input of amplifier A2. Amplifier A2 includes an output applied to an amplifier input A3. Amplifier A3 has an output that is typically applied to subsequent signal processing circuitry. A control circuit generates a control voltage Vc that is applied directly to amplifier A3 and is denoted control voltage Vc3. Control voltage Vc is also applied to a first input of a conventionally constructed voltage offset circuit Vos. A second terminal of the voltage offset circuit is applied simultaneously to control input to amplifier A2, Vc2, and to a first terminal of an identically constructed voltage offset circuit Vos2. The second terminal of voltage source Vos2 is coupled to a control voltage input Vc1 of amplifier A1. Control circuit is supplied with an input from an AGC circuit.

**Claims**

1. A method of producing a variable gain current output signal in a differential pair amplifier having a control voltage input to a voltage offset ladder circuit (8089) controlling a variable impedance, the variable impedance including a plurality of degeneration resistance circuits, and having the variable impedance coupled to the differential pair amplifier, comprising:

   applying a control voltage to a first degeneration resistance circuit;
   superimposing a voltage offset on to the control voltage in the voltage offset ladder (8089) to form a first offset control voltage;
   applying the first offset control voltage to a second degeneration resistance circuit; and
   coupling the variable impedance, including the plurality of degeneration resistance circuits, to the differential pair amplifier.

2. An apparatus for producing a variable gain current output signal in a differential pair amplifier having a control voltage input to a voltage offset ladder circuit (8089) controlling a variable impedance, the variable impedance including a plurality of degeneration resistance circuits, and having the variable impedance coupled to the differential pair amplifier,

the apparatus comprising:

means for applying a control voltage to a first degeneration resistance circuit;
means for superimposing a voltage offset on to the control voltage in the voltage offset ladder (8089) to form a first offset control voltage;
means for applying the first offset control voltage to a second degeneration resistance circuit; and
means for coupling the variable impedance, including the plurality of degeneration resistance circuits, to the differential pair amplifier.

## Patentansprüche

1. Verfahren zum Erzeugen eines Stromausgangssignals mit variabler Verstärkung in einem Differenzpaarverstärker mit einem Steuerspannungseingang zu einer Spannungsversatz-Leiterschaltung (8089), die eine variable Impedanz steuert, wobei die variable Impedanz eine Vielzahl von Degenerationswiderstandsschaltungen aufweist, und wobei die variable Impedanz an den Differenzpaarverstärker gekoppelt ist, wobei das Verfahren umfasst:

   Anlegen einer Steuerspannung an eine erste Degenerationswiderstandsschaltung;
   Überlagern eines Spannungsversatzes auf die Steuerspannung in der Spannungsversatz-Leiterschaltung (8089), um eine erste Versatzsteuerspannung auszubilden;
   Anlegen der ersten Versatzsteuerspannung an eine zweite Degenerationswiderstandsschaltung; und
   Koppeln der variablen Impedanz, einschließlich der Vielzahl von Degenerationswiderstandsschaltungen, an den Differenzpaarverstärker.

2. Vorrichtung zum Erzeugen eines Stromausgangssignals mit variabler Verstärkung in einem Differenzpaarverstärker mit einem Steuerspannungseingang zu einer Spannungsversatz-Leiterschaltung (8089), die eine variable Impedanz steuert, wobei die variable Impedanz eine Vielzahl von Degenerationswiderstandsschaltungen aufweist, und wobei die variable Impedanz an den Differenzpaarverstärker gekoppelt ist, wobei die Vorrichtung aufweist:

   eine Einrichtung zum Anlegen einer Steuerspannung an eine erste Degenerationswiderstandsschaltung;
   eine Einrichtung zum Überlagern eines Spannungsversatzes auf die Steuerspannung in der Spannungsversatz-Leiterschaltung (8089), um eine erste Versatzsteuerspannung auszubilden;
   eine Einrichtung zum Anlegen der ersten Versatzsteuerspannung an eine zweite Degenerationswiderstandsschaltung; und
   eine Einrichtung zum Koppeln der variablen Impedanz, einschließlich der Vielzahl von Degenerationswiderstandsschaltungen, an den Differenzpaarverstärker.

## Revendications

1. Procédé de production d'un signal de sortie de courant à gain variable dans un amplificateur à paire différentielle ayant une entrée de tension de commande dans un circuit d'échelle à décalage de tension (8089) commandant une impédance variable, l'impédance variable incluant une pluralité de circuits résistifs à contre-réaction, et ayant l'impédance variable couplée à l'amplificateur à paire différentielle, comprenant :

   l'application d'une tension de commande à un premier circuit résistif à contre-réaction ;
   la superposition d'un décalage de tension sur la tension de commande dans l'échelle à décalage de tension (8089) pour former une première tension de commande décalée ;
   l'application de la première tension de commande décalée à un deuxième circuit résistif à contre-réaction ; et
   le couplage de l'impédance variable, incluant la pluralité de circuits résistifs à contre-réaction, à l'amplificateur à paire différentielle.

2. Appareil de production d'un signal de sortie de courant à gain variable dans un amplificateur à paire différentielle ayant une entrée de tension de commande dans un circuit d'échelle à décalage de tension (8089) commandant une impédance variable, l'impédance variable incluant une pluralité de circuits résistifs à contre-réaction, et ayant l'impédance variable couplée à l'amplificateur à paire différentielle, l'appareil comprenant :

   un moyen pour appliquer une tension de commande à un premier circuit résistif à contre-réaction ;

un moyen pour superposer un décalage de tension sur la tension de commande dans l'échelle à décalage de tension (8089) pour former une première tension de commande décalée ;

un moyen pour appliquer la première tension de commande décalée à un deuxième circuit résistif à contre-réaction ; et

un moyen pour coupler l'impédance variable, incluant la pluralité de circuits résistifs à contre-réaction, à l'amplificateur à paire différentielle.

## FIG.1

EP 1 681 764 B1

FIG.2

EP 1 681 764 B1

## FIG.3

Itot=1 ASSUMED
FOR THIS PLOT

FIG.4

EP 1 681 764 B1

## FIG.5a

## FIG.5b

EP 1 681 764 B1

FIG.5c

## FIG.6

## FIG.7a

FIG.7b

EP 1 681 764 B1

FIG. 7c

FIG.7d

In-

Io-

8085

n2

I2

*FIG.7e*

Vc

Variable Transconductance 8087

8081

RE

Io+

8083

n1

In+

I1

FIG.7f

FIG.7g

FIG.7h

EP 1 681 764 B1